# EUROPÄISCHE PATENTSCHRIFT

(11) **EP 3 737 890 B1**
(45) Veröffentlichungstag und Bekanntmachung des Hinweises auf die Patenterteilung: **10.08.2022**
(21) Anmeldenummer: 18830437.2
(22) Anmeldetag: 17.12.2018
(51) Int. Cl.: F24C 7/08, G06F 3/0338, H03K 17/97, D06F 39/00, H05B 6/12, H03K 17/965

(54) **HAUSHALTSGERÄT**
HOUSEHOLD APPLIANCE
APPAREIL ÉLECTROMÉNAGER

(30) Priorität: 11.01.2018 DE 102018200337
(43) Veröffentlichungstag der Anmeldung: 18.11.2020
(73) Patentinhaber: BSH Hausgeräte GmbH, 81739 München (DE)
(72) Erfinder: ALT, René, 83624 Otterfing (DE); BELIVEAU, Thomas Eric, 80798 München (DE); SCHMIDT, Tobias, 81371 München (DE); SCHUMACHER, Frank, 80337 München (DE)
(86) Internationale Anmeldenummer: PCT/EP2018/085220
(87) Internationale Veröffentlichungsnummer: WO 2019/137742

(56) Entgegenhaltungen:
- EP-A1- 2 597 377
- EP-A1- 2 669 582
- EP-A2- 1 901 005
- WO-A2-2005/019987
- WO-A2-2009/084930
- DE-A1- 4 432 399
- DE-A1-102016 003 054
- DE-U1-202005 019 978
- US-A1- 2011 134 025
- US-A1- 2014 340 372

## Beschreibung

Die vorliegende Erfindung betrifft ein Haushaltsgerät gemäß dem Oberbegriff des Patentanspruchs 1.

Ein derartiges Haushaltsgerät in Form eines Kochfeldes ist aus der Druckschrift DE 10 2006 034 391 A1 bekannt. Diese weist ein Bedienelement mit wenigstens einem zumindest magnetisierbaren Element zum Positionieren des Bedienelements an einer definierten Position des Kochfeldes auf. Das Bedienelement weist ferner eine Standfläche zum Abstützen auf dem Kochfeld in einer Ruheposition auf. Eine die Standfläche umgebende Auflagefläche ist zum Abstützen des Bedienelements in einer Kippposition vorgesehen.

Aus der WO 2005/019987 A2 ist ein Eingabegerät bekannt, welches als Touchpad ausgebildet ist. Zur Erhöhung der Funktionalität des Touchpads ist dieses beweglich ausgebildet. Das Eingabegerät kann als freistehende Einheit ausgebildet sein, oder in ein elektronisches Gerät integriert sein.

Die US 2014/340372 A1 offenbart ein Bedienelement, welches einen Rahmen mit einem Bodenteil und einem Oberteil aufweist. Zwischen dem Bodenteil und dem Oberteil, welche starr miteinander verbunden sind, ist eine Betätigungsbaugruppe angeordnet. Innerhalb des Rahmens sind eine Vielzahl von Sensoren angeordnet, welche in Verbindung mit der Betätigungsbaugruppe zum Sensieren von Positionsinformationen vorgesehen sind.

Aus der EP 2 597 377 A1 ist eine Bedieneinrichtung für ein Haushaltsgerät bekannt, die eine Bedienelementaufnahme mit einer Vertiefung aufweist. Ein Bedienelement ist entnehmbar in der Vertiefung positionierbar.

Die DE 20 2005 019 978 U1 offenbart eine Bedienvorrichtung für ein Elektrogerät mit einer Bedieneinheit, welche drehbeweglich oder schiebebeweglich an einer Blende des Elektrogerätes gehaltert ist und einen Dreh- oder Schieberegler umfasst, welcher mindestens ein weiteres Schaltmittel aufweist.

Die DE 10 2016 003 054 A1 offenbart eine Formgebungsmaschine mit einer Bedieneinheit und einem Bedienelement, welches eine Signalvorrichtung aufweist, die die Bediensignale zumindest abschnittsweise kabellos signalübertragend an einen Prozessor der Bedieneinheit überträgt.

Der Erfindung liegt die Aufgabe zugrunde, den genannten Stand der Technik zu verbessern.

Diese Aufgabe wird durch ein Haushaltsgerät mit den Merkmalen des Patentanspruchs 1 gelöst. Vorteilhafte Ausgestaltungen sind den Unteransprüchen einzeln oder in Kombination zu entnehmen.

Gemäß dem kennzeichnenden Teil des Patentanspruchs 1 weist das Bedienelement einen gegenüber der Bedienblende feststehenden Stator und einen beweglich daran gelagerten Rotor auf. Aufgrund des im Wesentlichen zweiteiligen Aufbaus, bei dem der Stator unbeweglich auf der Bedienblende durch Magnetkraft gehalten wird, ist eine präzise Drehbewegung des Rotors ermöglicht. Eine schlingernde Drehbewegung des Bedienelements bezüglich einer Auflagefläche an der Bedienblende ist dadurch vermieden. Im Gegensatz zum einteilig ausgebildeten Bedienelement sind bei einem zweiteiligen Aufbau mehr Freiheitgerade bezüglich Führungskonturen für eine präzise Drehbewegung möglich, ohne dass ein Benutzer dadurch optische Nachteile in Kauf nehmen muss. Gleiches trifft für die Kippbewegung zu, die durch den zweiteiligen Aufbau ebenfalls präziser und für den Benutzer mit besserer Haptik erfolgt. Die Zweiteiligkeit des Aufbaus bezieht sich dabei auf das Grundprinzip mit Stator und Rotor. Der Rotor kann sich aber beispielsweise aus mehreren zueinander beweglich gelagerten Komponenten zusammensetzen, welche in ihrem Zusammenspiel eine besonders gut sensierbare und komfortabel zu bedienende Kipp-und Drehmechanik bereitstellen.

Das Bedienelement ist durch Magnetkraft in einer vordefinierten Position an der Bedienblende des Haushaltsgeräts gehaltert und kann durch den Benutzer jederzeit zerstörungsfrei von dieser gelöst werden. Die Bedienblende ist bevorzugt eben und frei von Durchbrüchen ausgestaltet. Dies ermöglicht dem Benutzer bei abgenommenem Bedienelement eine leichte Reinigung der Bedienblende. Der zweiteilige Aufbau des Bedienelements ermöglicht zudem einen Einsatz bei vertikal angeordneten Bedienblenden, wie sie beispielsweise Backöfen aufweisen, da der auf der Bedienblende angeordnete Stator sich gegenüber dieser nicht bewegt. Ein schwerkraftbedingtes Ablösen bei ungeschickter Drehbewegung durch einen Benutzer des Haushaltsgerätes wird durch den zweiteiligen Aufbau erschwert.

Der Stator weist eine ebene Anlagefläche für die Bedienfläche auf, wodurch diese flächig auf der Bedienfläche aufliegt und einen sicheren Halt ermöglicht. Im Gegensatz dazu weisen einteilig ausgebildete Bedienelemente häufig eine gekrümmte Bodenfläche auf, um die Drehbewegung auf der Bedienblende zu erleichtern. Diese gekrümmte Bodenfläche kontaktiert nur in ihrem Zentralbereich die Bedienblende, wodurch sich eine schlingernde Drehbewegung ergibt. Der Stator des erfindungsgemäßen Bedienelements kann zur weiteren Verbesserung der Fixierung an der Bedienblende zusätzlich noch mit rutschhemmendem Material an seiner Anlagefläche zur Bedienblende ausgerüstet sein. Dieses kann die Anlagefläche vollflächig bedecken oder nur partiell, z.B. in Form von streifenartigen oder ringartigen Elementen, die beispielsweise in entsprechende Vertiefungen der Statorunterseite eingelegt werden, an dieser angeordnet sein. Der Stator kann aber auch als Kunstoffspritzgussteil in 2K-Technik ausgebildet sein, bei dem das rutschhemmende Material in einen Basiskörper aus Standard-Kunststoff mit eingespritzt wird.

Um einen Benutzer ein angenehmes Bediengefühl zu vermitteln, weist das Bedienelement bevorzugt einen Durchmesser zwischen 35mm und 60mm auf. Die Höhe des Bedienelements beträgt vorzugsweise zwischen 5mm und 20mm, insbesondere zwischen 5mm und 13mm. Ein Kippwinkel des Rotors gegenüber dem Stator beträgt bevorzugt zwischen 2° und 10°, insbesondere zwischen 2° und 4°.

Zumindest ein Magnet ist zur räumlichen Positionierung des Rotors gegenüber dem Stator vorgesehen. Daraus ergibt sich der Vorteil, dass Rotor und Stator für Reinigungszwecke werkzeuglos voneinander trennbar sind. Der Magnet ist dabei beispielsweise im Rotor angeordnet und wirkt mit einem ferromagnetischen Metallstück im Stator zusammen. Dieses ist bevorzugt scheibenartig ausgebildet, wodurch eine reduzierte Bauhöhe des Stators und somit des gesamten Bedienelements ergibt. Das ferromagnetische Metallstück wirkt zudem mit einem unterhalb der Bedienblende angeordneten Magneten zusammen und fixiert den Stator lösbar an dieser.

Es weisen sowohl der Stator als auch der Rotor jeweils mindestens einen Magneten auf, um höhere Magnetkräfte zu erreichen. Die Magnete in Rotor und Stator sind dabei insbesondere derart ausgerichtet, dass sie gegenüberliegend angeordnet sind und somit ein Magnetpaar bilden. Zur genaueren Positionierung sind die Magnete jeweils in einer Aussparung des Stators und des Rotors angeordnet, welche in Richtung einer Rotationsachse betrachtet, genau gegenüberliegend ausgebildet sind. Ist unterhalb der Bedienblende ebenfalls ein Magnet angeordnet, der mit dem Magneten im Stator zusammenwirkt, ist das Bedienelement auch an dicken Bedienblenden, wie z.B. bei einer Kochfeldplatte, sicher fixierbar.

Bilden die Magnete von Stator und Rotor ein gegenüberliegend angeordnetes Magnetpaar, dessen einander zugewandte Magnetflächen unterschiedliche Polung aufweisen, ziehen sich Stator und Rotor gegenseitig an. Das zweiteilige Bedienelement wird dadurch lösbar zusammengehalten. Im Rotor und/oder Stator ist vorzugsweise eine Kerbe ausgespart, die z.B. in Verbindung mit einem Schraubendreher einem Benutzer das Trennen von Rotor und Stator zu Reinigungszwecken ermöglicht. Die Kerbe ist dabei bevorzugt derart angeordnet, dass sie nur von einer Unterseite des Bedienelements, also in Blickrichtung zur Auflagefläche des Stators für den Benutzer sichtbar ist.

Bevorzugt sind die beiden Magnete konzentrisch bezüglich einer gemeinsamen Rotationsachse von Rotor und Stator angeordnet. Die Rotationsachse entspricht dabei einer Symmetrieachse des Bedienelements. Die Magnete von Rotor und Stator sind dabei bevorzugt zylindrisch ausgebildet. Zudem weisen Sie insbesondere einen gleichen Durchmesser auf. Der Magnetdurchmesser beträgt dabei bevorzugt zwischen 6 mm und 13 mm.

Eine magnetische Haltekraft zwischen Stator und Rotor ist größer als eine magnetische Haltekraft zwischen Stator und Bedienblende, wodurch das Bedienelement von der Bedienblende abgenommen werden kann, ohne dass sich Rotor und Stator voneinander lösen. Insbesondere ist dabei im Stator lediglich ein einziger Magnet angeordnet, der zur Befestigung des Bedienelements an der Bedienblende und auch zur Befestigung des Stators am Rotor ausgelegt ist. Unterhalb der Bedienblende ist vorzugsweise ein weiterer Magnet angeordnet, der mit dem Magnet im Stator zusammenwirkt und das Bedienelement sicher an der Bedienblende hält. Die Auslegung des Magnetpaares von Stator und Bedienblende ist wesentlich von Material und Dicke der Bedienblende abhängig.

Bevorzugt weisen Stator und Rotor jeweils eine zur Rotationsachse konzentrische Reibfläche auf, die mittels Magnetkraftkraft kraftschlüssig miteinander verbunden sind und eine Gleitpaarung bilden. Der Durchmesser der gegenüberliegend angeordneten Reibflächen beträgt dabei bevorzugt weniger als 20 mm, insbesondere weniger als 13 mm. Dadurch ist eine angenehme Haptik bei einer Kipp-Bewegung des Rotors gegenüber dem Stator gewährleistet. Die Reibflächen sind horizontal, bzw. parallel zur Bedienblende ausgerichtet und können jeweils als Vollkreisflächen oder als Kreisringflächen ausgebildet sein. Die Reibflächen von Rotor und Stator werden durch die sich anziehenden Magnetkräfte der in Stator und Rotor eingebetteten Magnete aufeinandergedrückt. Die beim Verdrehen des Rotors gegenüber dem Stator entstehende Reibung bestimmt neben der wirksamen magnetischen Feldstärke die die Haptik beim Drehen. Die Reibfläche des Stators kann dabei beispielsweise durch die Stirnfläche, bzw. Polfläche des darin angeordneten, z.B. galvanisch beschichteten Magneten gebildet sein, während der Gegenpart des Rotors aus einer kreisrunden oder kreisringförmigen Kunststofffläche gebildet ist. Die Reibflächen können auch durch spezielle Einsätze aus Kunststoffmaterial, welche jeweils in das Grundmaterial von Stator und Rotor eingebettet sind, erzeugt werden. Dadurch kann eine zur angenehmen Haptik erforderliche Gleitpaarung bereitgestellt werden.

Um eine Kippbewegung des Rotors zu ermöglichen, ist zwischen Stator und Rotor ein Spalt ausgebildet, der sich beginnend ab dem Ende der Reibfläche bezüglich der Rotationsachse radial nach außen vergrößert. Der Spaltwinkel beträgt dabei im betriebsmäßig gekoppelten Zustand von Stator und Rotor bevorzugt zwischen 2° und 10°, insbesondere zwischen 2° und 4°. Der Spalt ist radial umlaufend um die Rotationsachse ausgebildet. Der Spalt weist im Anschluss an die Reibflächen bevorzugt eine längere, nach oben hin und entsprechend von der Bedienblende wegführende, erste Komponente auf. An diese schließt sich eine vertikal nach unten zur Bedienblende hin gerichtete, zweite Komponente an. Der Spalt hat dadurch einen hakenförmigen Querschnitt. Durch Drücken auf einer beliebigen Stelle am äußeren Rand des Rotors ergibt sich eine Kippbewegung, bei der partiell der Spalt bis auf null reduziert wird. Die sich anziehenden Magnetkräfte im Bereich der Reibflächen bewirken ein entsprechendes Rückstellmoment des Rotors in eine parallel zum Stator, bzw. zur Bedienblende ausgerichtete Lage.

In einer alternativen Ausbildung bilden die Magnete von Stator und Rotor zumindest ein gegenüberliegend angeordnetes Magnetpaar, dessen einander zugewandte Magnetflächen gleiche Polung aufweisen. Dadurch ergibt sich eine abstoßende Kraft zwischen Stator und Rotor, die beispielsweise durch Ausbildung eines Hinterschnitts im Rotor oder im Stator konstruktiv abgefangen wird.

In der alternativen Ausbildung weist das Bedienelement mehrere gegenüberliegend angeordnete, gleichpolige Magnetpaare auf, die gleichmäßig verteilt in einer konzentrischen Umlaufbahn um eine gemeinsame Rotationsachse angeordnet sind. Dadurch ergibt sich eine flächig wirkende, abstoßende Kraft, wodurch der Rotor schwebend auf dem Stator gelagert ist.

Vorzugsweise stützt sich dabei der Rotor durch einen Hinterschnitt am Stator derart ab, dass die Innenseite des Rotors in einem definierten Abstand zum Stator positioniert ist. Der definierte Abstand ist beispielsweise durch einen gleichmäßigen, parallel zur Bedienblende ausgerichteten Spalt gebildet. Der Hinterschnitt bildet einen Anschlag für die sich abstoßenden Magnetkräfte von Rotor und Stator. Der Hinterschnitt ist derart ausgebildet, dass er in einer Ruheposition des Rotors im Wesentlichen horizontal, bzw. parallel zur Bedienblende ausgerichtet ist. Bevorzugt weist eine Gleitfläche des Hinterschnitts, welche eine Gleitfläche des Stators kontaktiert, eine Schräge auf, die in Richtung Rotationsachse zur Bedienblende hin geneigt ist. Durch diese Schräge ergibt sich eine Zentrierung des Rotors bezüglich der Rotationsachse. Eine Drehbewegung des Rotors ist in seiner Haptik neben der wirkenden Magnetkraft durch die Gleitpaarung der Materialien von Hinterschnitt und Gleitfläche des Stators bestimmt. Für eine besonders komfortable Haptik bei der Drehbewegung kann ein Wälzlager vorgesehen sein. Dieses kann beispielsweise als axiales Kugellager ausgebildet sein, an dem der sich der Hinterschnitt abstützt. Eine Kippbewegung wird ermöglicht, indem durch Drücken am äußeren Rand des Rotors der Spalt entgegen der Magnetkraft an dieser Stelle auf null reduziert wird. Nach dem Drücken wird der Rotor durch die sich abstoßenden Magnetkräfte automatisch wieder in die horizontale, bzw. zur Bedienblende parallele Position bewegt. Alternativ dazu kann auch der Stator mit Hinterschnitt ausgebildet sein.

Bevorzugt ist es, wenn die Dreh- und Kippbewegung des Rotors durch Sensoren über eine Steuereinrichtung des Haushaltsgerätes auswertbar ist, welche Sensoren bezüglich einer Auflageposition des Bedienelements auf einer gegenüberliegenden Seite der Bedienblende angeordnet sind. Die Sensoren können auf optischen, kapazitiven oder auf induktiven Wirkprinzipien beruhen. Beispielsweise kann eine Kippbewegung des Rotors durch den reduzierten Abstand eines metallisch ausgebildeten und mit einem Magneten gekoppelten Seitenteils, bzw. Halterings zur Bedienblende mittels Hall-Sensoren erfasst werden. Eine Drehbewegung des Rotors kann beispielsweise optisch ausgewertet werden, indem eine der Bedienblende zugewandte Seitenwand des Rotors abwechselnd unterschiedliche Oberflächenrauhigkeiten und damit ein unterschiedliches Reflexionsverhalten aufweist. Das Bedienelement selbst ist dabei bevorzugt passiv ausgebildet und benötigt keinerlei eigene Energieversorgung. Die Sensoren sind mit einer Steuereinrichtung des Haushaltsgerätes verbunden, welche beispielsweise eine Leistungseinstellung von Heizeinrichtungen oder eine Zeiteinstellung eines Timers durch die Dreh- und Kippbewegung des Bedienelements ermöglicht.

Weitere Merkmale und Vorteile der Erfindung ergeben sich aus der nachfolgenden Beschreibung zweier Ausführungsbeispiele unter Bezugnahme auf die beigefügten schematischen Figuren. Es zeigen:
**Fig.1** ein Kochfeld mit der erfindungsgemäßen Bedienvorrichtung;
**Fig.2** einen Backofen mit der erfindungsgemäßen Bedienvorrichtung;
**Fig.3** einen Bedienelement in einer ersten Ausbildung in Schnittdarstellung;
**Fig.4** eine explodierte Schnittdarstellung des Bedienelements aus Fig. 3;
**Fig.5** ein Bedienelement in einer zweiten Ausbildung in Schnittdarstellung;
**Fig.6** das Bedienelement aus Fig. 5 in Kippposition und
**Fig.7** das Bedienelement aus Fig. 5 als explodierte Schnittdarstellung.

In den Figuren werden gleiche oder funktionsgleiche Elemente mit den gleichen Bezugszeichen versehen.

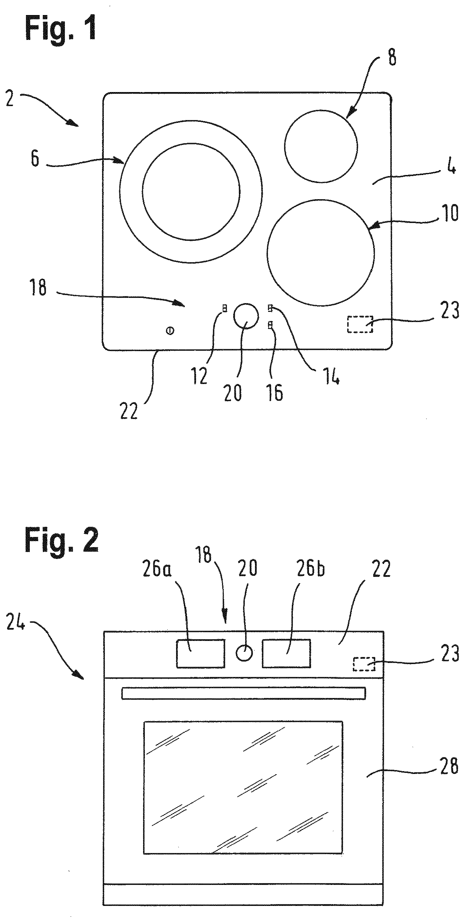

**Fig.1** zeigt ein Kochfeld 2 mit einer Glaskeramikplatte 4 und darauf angeordneten Kochzonen 6, 8 und 10, welche über die Bedienvorrichtung 18 in Verbindung mit einer Steuereinrichtung 23 in ihrer Leistung einstellbar sind. Unterhalb jeder Kochzone, auf einer dem Benutzer abgewandten Seite der Glaskeramikplatte 4 ist für jede der Kochzonen 6, 8 und 10 zumindest eine Heizeinrichtung (nicht gezeigt) angeordnet, die als Induktions- oder Strahlungsheizeinrichtung ausgebildet sein kann. Die Bedienvorrichtung 18 ist auf der Bedienblende 22 angeordnet, welche durch einen Teilbereich der Glaskeramikplatte 4 gebildet ist. Die Bedienvorrichtung 18 weist ein flaches und im wesentlichen zylinderförmiges Bedienelement 20 auf, um das ringförmig Anzeigen 12, 14 und 16 angeordnet sind, die eine jeweils den Kochzonen 6, 8 und 10 zugewiesene Leistung anzeigen. Die geometrische Anordnung der Anzeigen 12, 14 und 16 entspricht im wesentlichen der geometrischen Anordnung der Kochzonen 6, 8 und 10 auf der Glaskeramikplatte 4.

**Fig. 2** zeigt einen Backofen 24, welcher eine Bedienvorrichtung 18 aufweist, die an einer Bedienblende 22 angeordnet ist. Unterhalb der Bedienblende 22 weist der Backofen 24 eine Backofentür 28 auf. Die Bedienvorrichtung 18 setzt sich aus einem flachen und im Wesentlichen zylinderförmigen Bedienelement 20, sowie einem linksseitig davon angeordneten Display 26a und einem rechtsseitig davon angeordneten Display 26b zusammen. Die Bedienblende 22 ist aus einer durchbruchsfreien Platte aus Kunststoff oder Glas hergestellt. Die Platte ist zumindest in Teilbereichen transparent ausgebildet und im Wesentlichen eben. Hinter der Bedienblende 22 ist für einen Benutzer unsichtbar eine Steuereinrichtung 23 angeordnet.

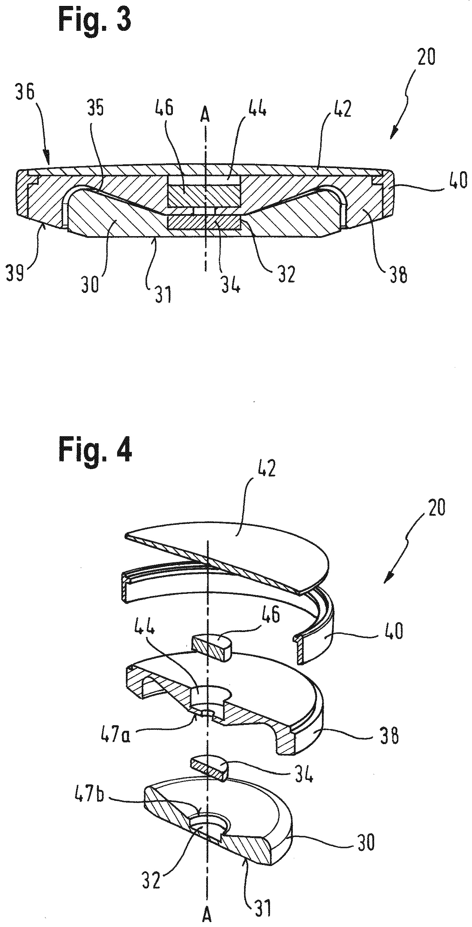

**Fig.3** zeigt die Schnittdarstellung des Bedienelements 20 in einer ersten Ausbildung. Ein zur Befestigung an der Bedienblende 22 ausgebildeter Stator 30 ist rotationssymmetrisch ausgebildet. Der Stator 30 weist an einer Unterseite eine Auflagefläche 31 auf, die magnetisch an der Bedienblende 22 fixierbar ist. Der Stator 30 weist zudem in seinem Zentrum eine Ausnehmung 32 auf, in die ein Magnet 34 eingesetzt ist. Der Magnet 34 ist derart ausgelegt, dass er den Stator 30 sicher auf der Bedienblende 22 des Haushaltsgerätes 2; 24 hält. Dadurch wird ein Verschieben des Stators 30 gegenüber der Bedienblende 22 bei der Deh- und Kippbewegungen eines umgreifend um den Stator 30 angeordneten Rotors 36 verhindert. Der Magnet 34 wirkt dabei mit einem nicht gezeigten Magneten der Bedienblende 22 zusammen. Der Magnet 34 wirkt zudem noch mit einem weiteren Magneten 46 des Rotors 36 zusammen, sodass der Rotor 36 verliersicher auf dem Stator 30 gelagert ist. Um dies zu erreichen sind die Magnete 34 vom Stator 30 und 46 vom Rotor 36 derart ausgelegt, dass die Haltekraft vom Rotor 36 am Stator 30 größer ist, als die Haltekraft vom Stator 30 an der Bedienblende 22. Somit ist ein Abnehmen des Bedienelements 20 von der Bedienblende 22 durch Ziehen am Rotor 36 möglich, ohne dass sich Rotor 36 und Stator 30 voneinander trennen. Dennoch kann ein Benutzer durch eine etwas höhere Krafteinwirkung Stator 30 und Rotor 36 für Reinigungszwecke voneinander trennen. Dafür ist im Stator 30 eine Kerbe (nicht gezeigt) ausgebildet, die das Ansetzen eines Schraubendrehers ermöglicht. Ein Benutzer kann somit unter Zuhilfenahme des Schraubendrehers Stator 30 und Rotor 36 ohne großen Kraftaufwand voneinander trennen.

Der Rotor 36 besteht aus einem Zylinderförmigen Träger 38, der eine M-förmige Ausnehmung an seiner dem Stator 30 zugewandten Innenseite aufweist. Im Träger 38 ist an einer vom Stator 30 abgewandten Seite eine Ausnehmung 44 für den Magneten 46 eingebracht. Der Rotor 36 ist ebenso wie das gesamte Bedienelement 20 rotationssymmetrisch bezüglich einer Rotationsachse A des Bedienelements 20 aufgebaut. Der Träger 38 weist eine Verkleidung, bestehend aus einem ringförmigen Seitenteil 40, und einer linsenförmigen Abdeckung 42 auf. Zwischen Stator 30 und Rotor 36 erstreckt sich im betriebsmäßig gekoppelten Zustand ein Spalt 35, der sich mit zunehmendem Abstand zu Rotationsachse A vergrößert. Der Spalt 35 folgt der Kontur der Stators 30 und ermöglicht eine Kippbewegung des Rotors 36. Träger 38 und Seitenteil 40 weisen eine zur Bedienblende 22 gerichtete Fläche 39 auf, die mit der Bedienblende einen spitzen Winkel bildet der sich mit zunehmendem Abstand von der Rotationsachse A vergrößert. Die Fläche 39 ist somit derart ausgebildet, dass bei einer Kippbewegung des Rotors 36 der Träger 38 und das Seitenteil 40 die Bedienblende 22 nicht touchieren. In einer Kippposition des Rotors 36 bildet die Fläche 39 im Wesentlichen einen parallelen Spalt zur Bedienblende 22.

**Fig.4** zeigt den napfförmig ausgebildeten Stator 30 mit einer Ausnehmung 32 für den Magneten 34. Eine parallel zur Auflagefläche 31 angeordnete, ringförmige Reibfläche 47b ist am Ende der Ausnehmung 32 angeordnet. Diese wirkt mit einer kreisförmigen Reibfläche 47a des Trägers 38 zusammen. Gegenüberliegend der Reibfläche 47a ist im Träger 38 die Ausnehmung 44 für den Magneten 46 angeordnet. Zur Verkleidung des Trägers 38 wird an diesem der Ring 40 sowie die Abdeckung 42 z.B. durch Verkleben befestigt.

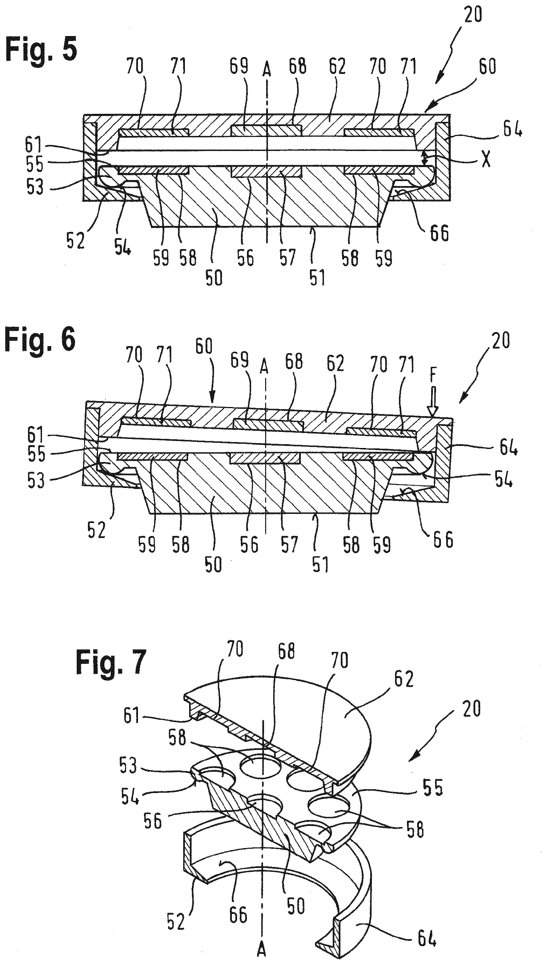

**Fig.5** zeigt eine Schnittdarstellung des Bedienelements 20 in einer zweiten Ausbildung. Diese weist einen Stator 50, sowie einen Rotor 60 auf, welche rotationssymmetrisch zu einer gemeinsamen Rotationsachse A ausgebildet sind. Der Stator 50 ist durch einen trapezförmigen Grundkörper gebildet, der mit einer Anlagefläche 51 auf der Bedienblende 22 des Haushaltsgerätes 2; 24 magnetisch fixierbar ist. An einer gegenüberliegenden Seite des Stators 50 ist im Randbereich mit Abstand ein Wulst 53 angeordnet, der eine Gleitfläche 54 aufweist. An einer der Bedienblende 22 abgewandten Seite des Stators 50 sind in einer ringförmigen Anordnung mehrere Aussparungen 58 für Ringmagnete 59 ausgebildet. Mittig zu Rotationsachse A ist zudem eine Aussparung 56 für den Zentralmagneten 57 ausgebildet.

Der Rotor 60 ist gegenüberliegend zur Anlagefläche 51 auf dem Stator 50 angeordnet und umgreift diesen teilweise. Der Rotor 60 ist rotationssymmetrisch bezüglich der Rotationsachse A ausgebildet. Der Rotor 60 weist an einer Innenseite 61 Aussparungen 70 auf, die sich ringförmig und jeweils gleich voneinander beanstandet um das Zentrum der Rotationsachse A erstrecken und in denen jeweils ein Ringmagnet 71 eingebettet ist. Konzentrisch zur Rotationsachse A ist eine Aussparung 68 für einen Zentralmagneten 69 vorgesehen. Die Ringmagnete 71 des Rotors 60 sind dabei spiegelbildlich zu den Ringmagneten 59 des Stators 50 angeordnet. Der Rotor 60 ist im Wesentlichen zweiteilig ausgebildet und setzt sich aus einem Träger 62 und einem Haltering 64 zusammen. Eine vom Stator 50 abgewandte Seite des Trägers 62 bildet eine obere Begrenzung des Bedienelements 20.

Der Haltering 64 bildet den wesentlichen Teil einer seitlichen Begrenzung des Bedienelements 20. Der Haltering 64 weist einen Hinterschnitt 52 auf, der mit seiner Gleitfläche 66 an der Gleitfläche 54 des Wulstes 53 vom Stator 50 anliegt. Das umlaufende Anliegen des Hinterschnitts 52 vom Haltering 64 an der Gleitfläche 54 des Stators 50 ergibt sich durch die jeweils gegenüberliegend angeordneten Magnete 59 und 57 des Stators zu den Magneten 71 und 69 des Rotors, welche an ihren sich gegenüberstehenden Magnetflächen jeweils gleiche Polarität aufweisen. Durch die damit verbundene Abstoßung wird der Rotor 60 in Richtung der Rotationsachse A vom Stator 50 weggedrückt. Es ergibt sich dadurch zwischen einer Oberseite 55 des Stators 50 und der Innenseite 61 des Rotors 60 ein paralleler, ringförmig ausgebildeter Spalt mit einem definierten Abstand X. Dieser Spalt ist durch die Position des Hinterschnitts 52 zur Innenseite 61 des Rotors 60 definiert.

Der Rotor 60 kann durch einen Benutzer gegenüber dem Stator 50, welcher mit seiner Anlagefläche 51 auf der Bedienblende 22 fixiert ist, verdreht werden, wodurch sich Betriebseinstellungen des Haushaltsgerätes 2; 24 ändern lassen. Die Drehkraft, bzw. die Haptik der Drehbewegung ist neben der Feldstärke der Magnete 57, 59, 69, und 71 auch von der Gleitpaarung der Gleitfläche 54 des Stators 50 zur Gleitfläche 66 des Rotors 60 abhängig. Durch entsprechende Materialauswahl der aufeinander gleitenden Flächen kann die Haptik der Drehbewegung entsprechend beeinflusst werden. Ein besonders leichtgängiges und komfortables Drehen kann durch den Einsatz eines Axialkugellagers erreicht werden.

Die Einwirkung einer Kraft F auf den Rand des Rotors 60 ist in **Fig.6** dargestellt. Durch die Kraft F wird die abstoßende Kraft der Ringmagnete 59 und 71 überwunden und die Innenseite 61 des Rotors 60 liegt auf der Oberseite 55 der Stators 50 im Krafteinwirkungsbereich partiell auf. Die Kraft F, welche durch einen Finger des Benutzers aufgebracht wird, muss dabei im Wesentlichen die abstoßende Kraft der Ringmagnete 59 und 71 überwinden. Der Haltering 64, welcher aus Metall besteht, ist somit näher an der Ebene der Auflagefläche 51 des Stators 50, und somit näher an der Bedienblende 22 angeordnet, was durch unterhalb der Bedienblende 22 angeordnete Sensoren des Haushaltsgerätes 2; 24 erkannt wird und wodurch ein entsprechender Steuerbefehl von der Steuereinrichtung 23 ausgegeben werden kann. Nach dem Loslassen des Fingers und der dadurch fehlenden Krafteinwirkung wird der Rotor 60 durch die abstoßende Kraft der Ringmagnete 59 und 71 wieder in seine zur Bedienblende 22 parallele Ausgangsposition zurückgedrückt.

**Fig.7** zeigt eine Explosionsdarstellungen des geschnittenen Bedienelements 20 in der zweiten Ausbildung. Zur Montage des Bedienelements 20 wird zunächst der Stator 50 in den Haltering 64 eingelegt. Anders als in Fig.7 gezeigt, müssen dabei vorher die Magnete 57, 59, 69, und 71 jeweils in den entsprechenden Aussparungen 56, 58, 68 und 70 befestigt werden. Die Befestigung der bevorzugt zylinderförmig ausgebildeten Magnete 57, 59, 69, und 71 kann dabei durch Klebe- und/oder Rastverbindungen erfolgen. Zur leichteren Montage sind die einzelnen Magnete 57, 59, 69, und 71 jeweils gleich groß ausgebildet, wodurch die Gefahr einer Fehlmontage verhindert wird. Zum Schluss wird der Träger 62 derart mit dem Haltering 64 verbunden, dass er ohne sich zu lösen zumindest die abstoßenden Magnetkräfte von Stator 50 und Rotor 60 aufnehmen kann. Dies kann beispielsweise durch eine Rastverbindung, eine Klebeverbindung oder eine Schraubverbindung erfolgen.

### Bezugszeichenliste:

2 Kochfeld
4 Glaskeramikplatte
6 Kochzone
8 Kochzone
10 Kochzone
12 Anzeige
14 Anzeige
16 Anzeige
18 Bedienvorrichtung
20 Bedienelement
22 Bedienblende
23 Steuereinrichtung
24 Backofen
26a Display
26b Display
28 Backofentür
30 Stator
31 Anlagefläche
32 Ausnehmung
34 Magnet
35 Spalt
36 Rotor
38 Träger
39 Fläche
40 Seitenteil
42 Abdeckung
44 Ausnehmung
46 Magnet
47a Reibfläche
47b Reibfläche
50 Stator
51 Anlagefläche
52 Hinterschnitt
53 Wulst
54 Geleitfläche
55 Oberseite
56 Aussparung Zentralmagnet
57 Zentralmagnet
58 Aussparung Ringmagnet
59 Ringmagnet
60 Rotor
61 Innenseite
62 Träger
64 Haltering
66 Gleitfläche
68 Aussparung Zentralmagnet
69 Zentralmagnet
70 Aussparung Ringmagnet
71 Ringmagnet
F Kraft
A Rotationsachse
x Abstand

## Patentansprüche

1. Haushaltsgerät (2, 24) mit einer Bedienvorrichtung, aufweisend ein Bedienelement (20), welches auf einer Bedienblende (22) des Haushaltsgeräts (2, 24) mittels Magnetkraft abnehmbar gehaltert ist und welches zur Bedienung dreh- und kippbar ist, wobei das Bedienelement (20) einen gegenüber der Bedienblende (22) feststehenden Stator (30, 50) und einen beweglich daran gelagerten Rotor (36, 60) aufweist, **dadurch gekennzeichnet, dass** zumindest ein Magnet (34, 46, 57, 59, 69, 71) zur räumlichen Positionierung des Rotors (36, 60) gegenüber dem Stator (30, 50) vorgesehen ist, und sowohl der Stator (30, 50) als auch der Rotor (36, 60) jeweils mindestens einen Magneten (34, 46, 57, 59, 69, 71) aufweisen und entweder eine magnetische Haltekraft zwischen Stator (30) und Rotor (36) größer ist, als eine magnetische Haltekraft zwischen Stator (30) und Bedienblende (22), oder die Magnete (57, 59, 69, 71) von Stator (50) und Rotor (60) zumindest ein gegenüberliegend angeordnetes Magnetpaar bilden, dessen einander zugewandte Magnetflächen gleiche Polung aufweisen, wobei das Bedienelement (20) mehrere gegenüberliegend angeordnete, gleichpolige Magnetpaare (59, 71) aufweist, die gleichmäßig verteilt in einer konzentrischen Umlaufbahn um eine gemeinsame Rotationsachse (A) von Stator (50) und Rotor (60) angeordnet sind.

2. Haushaltsgerät nach Anspruch 1, **dadurch gekennzeichnet, dass** die Magnete (34, 46) von Stator (30) und Rotor (36) ein gegenüberliegend angeordnetes Magnetpaar bilden, dessen einander zugewandte Magnetflächen unterschiedliche Polung aufweisen.

3. Haushaltsgerät nach einem der vorhergehenden Ansprüche, **dadurch gekennzeichnet, dass** die beiden Magnete (34, 46, 57, 69) konzentrisch bezüglich einer gemeinsamen Rotationsachse (A) von Rotor (36, 60) und Stator (30, 50) angeordnet sind.

4. Haushaltsgerät nach einem der vorhergehenden Ansprüche, **dadurch gekennzeichnet, dass** Stator (30) und Rotor (36) jeweils eine zur Rotationsachse (A) konzentrische Reibfläche (47a, 47b) aufweisen, die mittels Magnetkraft kraftschlüssig miteinander verbunden sind und eine Gleitpaarung bilden.

5. Haushaltsgerät nach Anspruch 4, **dadurch gekennzeichnet, dass** zwischen Stator (30) und Rotor (36) ein Spalt (35) ausgebildet ist, der sich beginnend vom Ende der Reibfläche (47a, 47b) bezüglich der Rotationsachse (A) radial nach außen vergrößert.

6. Haushaltsgerät nach Anspruch 1, **dadurch gekennzeichnet, dass** der Rotor (60) sich durch einen Hinterschnitt (52) am Stator (50) derart abstützt, dass eine Innenseite (61) des Rotors (60) in einem definierten Abstand (x) zum Stator (50) positioniert ist.

7. Haushaltsgerät nach einem der vorhergehenden Ansprüche, **dadurch gekennzeichnet, dass** eine Dreh- und Kippbewegung des Rotors (36, 60) durch Sensoren über eine Steuereinrichtung (23) des Haushaltsgerätes (2, 24) auswertbar ist, welche Sensoren bezüglich einer Auflageposition des Bedienelements (20) auf einer gegenüberliegenden Seite der Bedienblende (22) angeordnet sind.

## Claims

1. Household appliance (2, 24) with a control device, having a control element (20) which is held removably on a control panel (22) of the household appliance (2, 24) by means of magnetic force and which can be rotated and tilted for control purposes, wherein the control element (20) has a stator (30, 50) which is fixed with respect to the control panel (22) and a rotor (36, 60) which is mounted movably thereon, **characterised in that** at least one magnet (34, 46, 57, 59, 69, 71) is provided for spatially positioning the rotor (36, 60) with respect to the stator (30, 50), and both the stator (30, 50) and also the rotor (36, 60) each have at least one magnet (34, 46, 57, 59, 69, 71) and either a magnetic holding force between stator (30) and rotor (36) is greater than a magnetic holding force between stator (30) and control panel (22) or the magnets (57, 59, 69, 71) of the stator (50) and rotor (60) form at least one pair of magnets arranged opposite one another, the magnetic surfaces of which facing one another have the same polarity, wherein the control element (20) has a number of homopolar pairs of magnets (59, 71) arranged opposite one another, which are arranged distributed uniformly in a concentric path about a shared axis of rotation (A) of the stator (50) and rotor (60).

2. Household appliance according to claim 1, **characterised in that** the magnets (34, 46) of the stator (30) and rotor (36) form a pair of magnets arranged opposite one another, the magnetic surfaces of which facing one another have a different polarity.

3. Household appliance according to one of the preceding claims, **characterised in that** the two magnets (34, 46, 57, 69) are arranged concentrically with respect to a shared axis of rotation (A) of the rotor (36, 60) and stator (30, 50).

4. Household appliance according to one of the preceding claims, **characterised in that** the stator (30) and rotor (36) each have a frictional surface (47a, 47b) which is concentric with respect to the axis of rotation (A), and which are connected to one another in a force-fit manner by means of magnetic force and form a tribological pairing.

5. Household appliance according to claim 4, **characterised in that** a gap (35) is embodied between the stator (30) and rotor (36) and extends radially outwards with respect to the axis of rotation (A) starting from the end of the frictional surface (47a, 47b).

6. Household appliance according to claim 1, **characterised in that** the rotor (60) abuts the stator (50) by means of an undercut (52) such that an interior (61) of the rotor (60) is positioned at a defined distance (x) from the stator (50).

7. Household appliance according to one of the preceding claims, **characterised in that** a rotational and tilting movement of the rotor (36, 60) can be evaluated by sensors by way of a control facility (23) of the household appliance (2, 24), which sensors are arranged on an opposing side of the control panel (22) with respect to a support position of the control element (20).

## Revendications

1. Appareil ménager (2, 24) comprenant un dispositif de commande, qui comprend un élément de commande (20), lequel est maintenu de façon détachable sur un panneau de commande (22) de l'appareil ménager (2, 24) au moyen d'une force magnétique, et peut être tourné et pivoté pour la commande, dans lequel l'élément de commande (20) comprend un stator (30, 50) monté fixe par rapport au panneau de commande (22) et un rotor (36, 60) monté de façon mobile sur celui-ci,
**caractérisé en ce qu'**au moins un aimant (34, 46, 57, 59, 69, 71) est prévu pour le positionnement spatial du rotor (36, 60) par rapport au stator (30, 50), et aussi bien le stator (30, 50) que le rotor (36, 60) comprennent chacun au moins un aimant (34, 46, 57, 59, 69, 71) et, ou bien une force magnétique de maintien entre le stator (30) et le rotor (36) est supérieure à une force magnétique de maintien entre le stator (30) et le panneau de commande (22), ou bien les aimants (57, 59, 69, 71) du stator (50) et du rotor (60) forment au moins une paire d'aimants disposés face à face, dont les surfaces magnétiques orientées l'une vers l'autre ont la même polarité, dans lequel l'élément de commande (20) comprend plusieurs paires d'aimants (59, 71) de même polarité disposées face à face, qui sont réparties régulièrement dans une orbite concentrique autour d'un axe de rotation (A) commun du stator (50) et du rotor (60).

2. Appareil ménager selon la revendication 1, **caractérisé en ce que** les aimants (34, 46) du stator (30) et du rotor (36) forment une paire d'aimants disposés face à face, dont les surface magnétiques tournées l'une vers l'autre ont une polarité différente.

3. Appareil ménager selon l'une des revendications précédentes, **caractérisé en ce que** les deux aimants (34, 46, 57, 69) sont disposés de manière concentrique par rapport à un axe de rotation (A) commun du rotor (36, 60) et du stator (30, 50).

4. Appareil ménager selon l'une des revendications précédentes, **caractérisé en ce que** le stator (30) et le rotor (36) comprennent chacun une surface de friction (47a, 47b) concentrique par rapport à l'axe de rotation (A), qui sont reliées l'une à l'autre par liaison de force au moyen d'une force magnétique et forment un couple de friction.

5. Appareil ménager selon la revendication 4, **caractérisé en ce qu'**un interstice (35) est formé entre le stator (30) et le rotor (36), lequel s'élargit radialement vers l'extérieur à partir de l'extrémité de la surface de friction (47a, 47b) par rapport à l'axe de rotation (A).

6. Appareil ménager selon la revendication 1, **caractérisé en ce que** le rotor (60) s'appuie sur le stator (50) par une contre-dépouille (52) de telle manière qu'une face intérieure (61) du rotor (60) est positionnée à une distance (x) définie du stator (50).

7. Appareil ménager selon l'une des revendications précédentes, **caractérisé en ce qu'**un mouvement de rotation et de pivotement du rotor (36, 60) peut être évalué par des capteurs via un dispositif de commande (23) de l'appareil ménager (2, 24), lesquels capteurs sont disposés, par rapport à une position d'appui de l'élément de commande (20), sur un côté opposé du panneau de commande (22).
